# EUROPÄISCHE PATENTSCHRIFT

(11) **EP 2 707 885 B1**
(45) Veröffentlichungstag und Bekanntmachung des Hinweises auf die Patenterteilung: **26.09.2018**
(21) Anmeldenummer: 12712992.2
(22) Anmeldetag: 15.03.2012
(51) Int. Cl.: H01F 5/04, H01R 12/58, H01R 12/51, B60T 8/36, H01F 7/06

(54) **ANSCHLUSSSTIFT**
CONNECTOR PIN
BROCHE DE CONNEXION

(30) Priorität: 15.03.2011 DE 102011005526; 11.08.2011 DE 102011080855
(43) Veröffentlichungstag der Anmeldung: 19.03.2014
(73) Patentinhaber: Continental Automotive GmbH, 30165 Hannover (DE)
(72) Erfinder: GRAF, Bernhard, 93053 Regensburg (DE); PUSCHER, Wolfgang, 93073 Neutraubling (DE); SCHOBER, Franz, 93077 Bad Abbach (DE); STÜRZER, Jürgen, 94330 Aiterhofen (DE)
(74) Vertreter: Brand, Markus
(86) Internationale Anmeldenummer: PCT/EP2012/054541
(87) Internationale Veröffentlichungsnummer: WO 2012/123534

(56) Entgegenhaltungen:
- EP-A2- 1 120 592
- DE-A1- 1 614 522
- DE-A1- 10 036 701
- DE-A1- 19 545 011
- US-A1- 2007 085 646

## Beschreibung

Die vorliegende Erfindung betrifft ein elektrisches Bauelement gemäß Anspruch 1 und eine Schaltung gemäß Anspruch 6.

Zum elektrischen Verbinden einer Leiterbahn eines elektrischen Bauelementes, insbesondere eines Spulendrahtes, mit einer Leiterbahn einer Leiterplatte können sogenannte Kontaktpins oder Anschlussstifte verwendet werden.

Elektronische bzw. elektrische Bauelemente, die über derartige Anschlussstifte an eine Leiterplatte angeschlossen werden nehmen teilweise sehr viel Platz auf der Leiterplatte ein.

Es ist Aufgabe der Erfindung den Platzbedarf von elektronischen bzw. elektrischen Bauelementen auf einer Leiterplatte zu senken, die über Anschlussstifte an die Leiterplatte angeschlossen sind.

Die Aufgabe wird durch die Merkmale des unabhängigen Anspruchs gelöst. Bevorzugte Weiterbildungen sind Gegenstand der abhängigen Ansprüche.

Der Erfindung liegt der Gedanke zugrunde, dass zum elektrischen Verbinden der Leiterbahnen eines elektrischen Bauelements und einer Leiterplatte zunächst der elektrische Kontakt zwischen der Leiterbahn am elektrischen Bauelement und dem Anschlussstift hergestellt wird. Erst danach wird der Anschlussstift elektrisch mit der Leiterbahn der Leiterplatte verbunden.

Der Erfindung liegt ferner die Erkenntnis zugrunde, dass für eine sichere elektrische Kontaktierung zwischen dem Anschlussstift und der Leiterbahn der Leiterplatte, der Anschlussstift axial auf die Leiterbahn der Leiterplatte gedrückt werden muss. Dies ist entweder notwendig, damit der Anschlussstift während der elektrischen Kontaktierung auf der Leiterbahn einen sicheren Halt hat oder damit die elektrische Kontaktierung selbst hergestellt werden kann, wie beispielsweise bei der Einpresstechnik.

Schließlich geht die Erfindung davon aus, dass beim Andrücken des Anschlussstifts auf die Leiterbahn der Leiterplatte der bereits bestehende elektrische Kontakt zwischen dem Anschlussstift und dem elektrischen Bauelement beschädigt werden kann. Dazu wird die Andruckkraft nicht über das elektrische Bauelement sondern mittels eines an dem Anschlussstift angreifenden Werkzeugs ausgeübt. Um diesen Angriff und die damit verbundene axiale Kraftübertragung überhaupt erst zu ermöglichen, muss der Anschlussstift herkömmlich mindestens einmal abgewinkelt sein, so dass das Werkzeug eine axiale Kraft vom Anschlussstift auf die Leiterbahn der Leiterplatte übertragen kann. Dieses herkömmlich notwendige Abwinkeln des Anschlussstifts führt zu Stellungen des elektrischen Bauelements und/oder des Anschlussstiftes, die den Platzbedarf des elektrischen Bauelements mit dem Anschlussstift auf der Oberfläche der Leiterplatte vergrößern und so gegebenenfalls eine unnötige Verlängerung der Leiterbahnen auf der Leiterplatte mit sich bringen.

Es wird weiter auf die Druckschrift EP 1 120 592 A2 verwiesen, welche die Merkmale des Oberbegriffs von Anspruch 1 zeigt und in der eine Steuereinheit für ein elektromagnetisches Ventil offenbart ist, bei welcher die elektromagnetische Spule elektrisch und mechanisch über eine Verbindungseinrichtung an die Steuereinheit angeschlossen ist.

Um diese Platz beanspruchenden Stellungen zu vermeiden schlägt die Erfindung vor, gerade, nicht abgewinkelte, Anschlussstifte zur elektrischen Kontaktierung der Leiterbahnen des elektrischen Bauelementes und der Leiterplatte zu verwenden. Um bei der elektrischen Kontaktierung des Anschlussstifts mit der Leiterbahn der Leiterplatte die Kontaktstelle zwischen dem Anschlussstift und der Leiterbahn des elektrischen Bauelements vor Beschädigungen zu schützen, schlägt die Erfindung vor, ein Stützelement am Anschlussstift auszubilden, das zur Aufnahme einer Kraft in Axialrichtung des Anschlussstifts vorgesehen ist.

Die Erfindung gibt daher ein elektrisches Bauelement gemäß Anspruch 1 mit einer Vorrichtung zum elektrischen Verbinden des elektrischen Bauelementes mit einer Leiterplatte an, die folgende Merkmale umfasst:
- einen elektrisch leitfähigen Anschlussstift mit einem ersten Kontaktbereich zum elektrischen Anschluss an die Leiterplatte und einem zweiten Kontaktbereich zum elektrischen Anschluss an das elektrische Bauelement; und
- ein den Anschlussstift haltendes Stützelement zwischen dem ersten und zweiten Kontaktbereich, das zur Aufnahme einer Kraft in Axialrichtung des Anschlussstiftes vorgesehen ist.

Das den Anschlussstift haltende Stützelement kann jede beliebige Form aufweisen, solange es ausgebildet ist, zum Anschlussstift axiale Kräfte aufzunehmen. Eine einstückige Ausbildung des Stützelements mit dem Anschlussstift ist daher genauso denkbar wie eine mehrstückige Ausbildung, wobei das Stützelement und der Anschlussstift miteinander fest verbunden werden. Auch in seiner Form ist das Stützelement nicht beschränkt. So kann das Stützelement beispielsweise in ein Gehäuse des elektronischen Bauelementes integriert werden, so dass das Gehäuse des elektrischen Bauelementes die auf den Anschlussstift wirkenden axialen Kräfte aufnehmen kann. In einer besonders einfachen Ausführung der Erfindung könnte das elektrische Bauelement per Hand auf die Leiterplatte zur elektrischen Kontaktierung aufgedrückt werden. Alternativ könnte das Stützelement mit Konturen ausgebildet sein, die besonders einfach zugänglich sind, indem sie vom elektrischen Bauelement hervorspringen, so dass die beim Aufdrücken auf die Leiterplatte entstehenden axialen Kräfte besonders einfach über das Stützelement aufgenommen werden können.

Die angegebene Vorrichtung erlaubt es, den Anschlussstift gerade auszubilden, so dass das entsprechende elektrische Bauelement senkrecht über der Leiterplatte stehen kann, ohne dass der Anschlussstift seitlich vom Bauelement hervorspringt. Auf diese Weise kann die Leiterplatte dichter mit elektrischen Bauelementen bestückt werden, wodurch der Platzbedarf deutlich reduziert wird. Überraschender Weise reduziert die Erfindung auch die Leistungsaufnahme der Leiterplatte, da die dichter gepackten elektrischen Bauelemente auf der Leiterplatte durch kürzere Leiterbahnen miteinander verbunden werden können. Die kürzeren Leiterbahnen senken Verlustwiderstände auf der Leiterplatte und verringern somit die Leistungsaufnahme der Leiterplatte.

Gemäß der Erfindung ist das Stützelement zur formschlüssigen Verbindung mit einem Gegenstück ausgebildet, das zur Aufnahme der Kraft in Axialrichtung des Anschlussstiftes vorgesehen ist. Die formschlüssige Verbindung kann in jeder erdenklichen Weise hergestellt werden. So kommen Schraubverbindungen genauso in Frage wie Bajonettverschlüsse und Schnapphakenverschlüsse. Durch die formschlüssige Verbindung kann das Stützelement und damit die angegebene Vorrichtung mit dem Anschlussstift kleiner und kompakter ausgebildet werden, da das eigentliche Element zur axialen Kraftaufnahme das Gegenstück darstellt. Zudem vereinfacht sich die Montage des elektrischen Bauelements, da das Gegenstück nicht an der angegebenen Vorrichtung vormontiert sein muss, sondern erst beim elektrischen Verbinden des elektrischen Bauelementes mit der Leiterplatte über die angegebene Vorrichtung an das Stützelement angeschlossen werden braucht. Gegebenenfalls könnte sogar ein einziges Gegenstück wie ein Werkzeug nach der elektrischen Kontaktierung wieder entfernt und für andere elektrische Kontaktierungen genutzt werden.

In einer bevorzugten Weiterbildung definiert die formschlüssige Verbindung eine eindeutige relative Lage des Stützelementes zum Gegenstück. Diese eindeutige Lage erlaubt es, die richtige Stellung des elektrischen Bauelementes auf der Leiterplatte vorzugeben. Dadurch wird nicht nur die Wahrscheinlichkeit für Montagefehler mit entsprechenden hohen Folgekosten minimiert, der Montageprozess selbst wird auch vereinfacht, da eine Verifikation der korrekten Stellung des elektrischen Bauelementes auf der Leiterplatte vor der elektrischen Kontaktierung vollständig entfallen kann.

In einer besonders bevorzugten Weiterbildung ist das Stützelement ein um den Anschlussstift umspritztes Spritzgusselement. Durch das Umspritzen lässt sich die Erfindung auf besonders kostengünstige Weise technisch realisieren, da jeder herkömmliche Anschlussstift mit dem Stützelement ausgestattet werden kann, ohne das sein Produktionsprozess selbst umgestellt werden müsste.

Die Erfindung nach Anspruch 1 gibt ein elektrisches Bauelement an, das folgende Merkmale umfasst:
- einen elektrischen Anschluss zum elektrischen Verbinden mit einer Leiterplatte; und
- eine angegebene Vorrichtung, wobei der zweite Kontaktbereich des Anschlussstiftes an den elektrischen Anschluss angeschlossen ist.

In einer Weiterbildung umfasst das elektrische Bauelement einen Spulenkörper oder Wickelkörper mit dem elektrischen Anschluss. In einem derartigen elektrischen Bauelement ist die angegebene Vorrichtung besonders günstig einsetzbar, da das Stützelement am Anschlussstift den Anwickelstift für den Spulenkörper begrenzen kann. Der Spulenkörper kann dabei auf einen Spulenträger aufgewickelt sein, der dem als Spule ausgebildeten elektrischen Bauelement insbesondere bei dünnen Spulendrähten eine ausreichende Stabilität verleiht.

In einer bevorzugten Weiterbildung ist der Spulenträger und das Stützelement einstückig miteinander ausgebildet, so dass die Kraft in Axialrichtung des Anschlussstiftes direkt auf den Spulenträger aufgebracht werden kann, ohne den elektrischen Kontakt zwischen dem Anschlussstift und dem Spulendraht zu beschädigen.

In einer besonders bevorzugten Weiterbildung können als Stützelement an den Spulenträger Formelemente angespritzt sein, die zur formschlüssigen Aufnahme eines Gegenstückes vorgesehen sind. Die angespritzten Formelemente können somit während der elektrischen Kontaktierung die Kraft in Axialrichtung des Anschlussstiftes vom Gegenstück auf den Anschlussstift übertragen. Alternativ können diese Formelemente auch direkt an den Spulenkörper oder Wickelkörper angespritzt sein.

In einer anderen Weiterbildung umfasst die Spule einen den Spulenkörper umgebenden Jochring. Diese Ausführungsform ist im Zusammenspiel mit der angegebenen Vorrichtung besonders günstig, da die Anschlussstifte nun vollständig unterhalb der Grundfläche des Spulenkörpers geführt werden können, und nicht mehr vom Umfang des Spulenkörpers abragen müssen. Auf diese Weise braucht eine Umfangsfläche des Jochrings zum Aufsetzen auf den Spulenkörper nicht mehr geschlitzt zu sein, um derartige abragende Anschlussstifte führen zu können. Durch den dadurch homogeneren Aufbau des Jochrings verbessern sich nicht nur die magnetischen Eigenschaften der Spule, es können auch Herstellungskosten gespart werden, da ein Schlitzen des Jochrings während der Herstellung der Spule entfällt.

Die Erfindung gibt auch eine Schaltung nach Anspruch 6 an, die folgende Merkmale umfasst:
- eine Leiterplatte; und
- ein angegebenes mit der Leiterplatte elektrisch kontaktiertes elektrisches Bauelement.

In einer Weiterbildung umfasst die Schaltung ein Gehäuse mit einem Gegenstück, das zum Abstützen auf dem Stützelement vorgesehen ist, so dass das Gehäuse eine Kraft in Axialrichtung des Anschlussstiftes auf das Stützelement ausüben kann. Das Gegenstück am Gehäuse erlaubt es insbesondere im Rahmen der Einpresstechnologie den Einbau der Leiterplatte in das Gehäuse sowie die Kontaktierung der Leiterplatte mit dem elektrischen Bauelement in einem einzigen Arbeitsschritt durchzuführen, so dass die Herstellung einer die Leiterplatte enthaltenden elektronischen Komponente beschleunigt werden kann. Zudem bietet das am Gehäuse ausgebildete Gegenstück dem elktrischen Bauelement auch während des gewöhnlichen Betriebes Halt, so dass das Gehäuse auch zum Stabilisieren des Bauelementes herangezogen werden kann.

Sollte das Gehäuse im Rahmen der Einpresstechnologie während eines Einpressvorgangs nicht stabil genug ausgebildet sein, um die Einpresskräfte aufzunehmen, kann das Gehäuse selbst, das elektrische Bauelement oder das Stützelement zusätzlich mit einem Werkzeug abgestützt werden, um die Einpresskräfte aufzunehmen.

Beschrieben wird auch ein Verfahren zum Herstellen einer Vorrichtung zum elektrischen Verbinden eines elektrischen Bauelementes mit einer Leiterplatte, das folgende Schritte umfasst:
- Ausbilden eines Anschlussstiftes mit einem ersten Kontaktbereich zum Anschluss an die Leiterplatte und einem zweiten Kontaktbereich zum Anschluss an das elektrische Bauelement; und
- Umspritzen des Anschlussstiftes zwischen dem ersten und zweiten Kontaktbereich insbesondere mit einem Kunststoff derart, dass der umspritzte Bereich am Anschlussstift eine Kraft in Axialrichtung des Anschlussstiftes aufnehmen kann.

Weiterbildungen des Verfahrens können Verfahrensschritte sein, die die Merkmale der angegebenen Vorrichtung, des Filters oder des Netzwerkes gemäß den Unteransprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
- Fig. 1: eine räumliche Darstellung eines für das Verständnis der Erfindung nützlichen Beispiels mit einem Fluchtpunkt in der Zeichnungsmitte;
- Fig. 2: eine räumliche Darstellung eines ersten Ausführungsbeispiels der Erfindung;
- Fig. 3: einen Ausschnitt der Darstellung aus Figur 2;
- Fig. 4: eine räumliche Darstellung eines zweiten Ausführungsbeispiels der Erfindung;
- Fig. 5: eine räumliche Darstellung eines dritten Ausführungsbeispiels der Erfindung; und
- Fig. 6: eine räumliche Darstellung eines vierten Ausführungsbeispiels der Erfindung zeigen.

Die Erfindung wird nachstehend anhand einer Spule beschrieben, die als elektrisches Bauelement mit einer Leiterplatte mittels Einpresstechnologie elektrisch kontaktiert werden kann.

Eine derartige Spule weist einen Spulenkörper oder Wickelkörper auf, der über einen Anschlussstift mit der Leiterplatte elektrisch kontaktiert werden kann. In der Einpresstechnik wird der Anschlussstift Einpresspin genannt, der vom Spulenkörper getragen wird. Während des Einpressvorgangs muss der Einpresspin mit einem externen Werkzeug direkt axial gegengehalten werden. Dies hat zur Folge, dass der Einpresspin mindestens einmal gewinkelt sein muss. Teilweise wird der Einpresspin sogar U- bzw. W-förmig gewinkelt. Die Spulenbefestigung beispielsweise am Gehäuse des gesamten Schaltungsaufbaus wird mit einem anderen Mechanismus beziehungsweise einem zusätzlichen Prozess gewährleistet. Der gewinkelte Einpresspin erfordert nicht nur, dass ein auf den Spulenkörper aufsetzbarer Jochring geschlitzt ausgeführt wird, der gesamte Spulenaufbau nimmt auf der Leiterplatte auch mehr Platz in Anspruch als nötig.

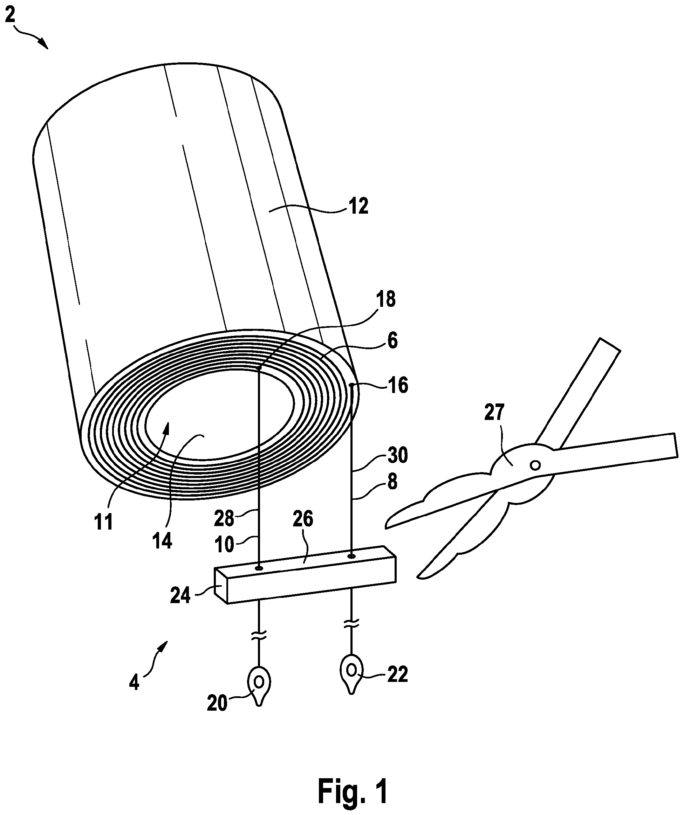

In Fig. 1 ist ein zum Verständnis der Erfindung nützliches Beispiel einer Spule 2 mit einer Vorrichtung 4 zum Verbinden der Spule mit einer Leiterplatte gezeigt.

Die Spule 2 umfasst einen gewickelten Spulendraht 6 und zwei Einpresspins 8, 10. Der gewickelte Spulendraht 6 begrenzt ein Domloch 11. Eine Mantelfläche 12 um den gewickelten Spulendraht 6 und eine zylindrische Innenwand 14 im Innenbereich des gewickelten Spulendrahtes 6 können zum Schutz mit einem Papier bedeckt sein.

Der erste Einpresspin 8 ist an einer ersten Kontaktstelle 16 mit einem Ende des gewickelten Spulendrahts 6 und der zweite Einpresspin 10 ist an einer zweiten Kontaktstelle 18 mit dem anderen Ende des gewickelten Spulendrahtes 6 elektrisch kontaktiert. Jeder Einpresspin 8, 10 weist eine Einpresszone 20, 22 auf, die in eine entsprechende Einpresshülse einer nicht gezeigten Leiterplatte eingepresst werden kann, um den elektrischen Kontakt mit der Leiterplatte herzustellen.

Zwischen den Kontaktstellen 16, 18 und den Einpresszonen 20, 22 ist an den Einpresspins 8, 10 ein gemeinsames Stützelement 24 mit einer Stützfläche 26 ausgebildet, auf die ein Werkzeug, wie beispielsweise eine Zange 27 aufgelegt werden kann, um die Einpresszonen 20, 22 der Einpresspins 8, 10 axial zu den Einpresspins 8, 10 in die Einpresshülsen der nicht gezeigten Leiterplatte einzupressen. Die Einpresspins 8, 10 bilden gemeinsam mit dem Stützelement 24 die Vorrichtung 4 gemäß der Erfindung.

Beispielhaft und nicht von der Erfindung umfasst können während des Einpressvorgangs die beiden Einpresspins 8, 10 zwischen die Zangenbacken der Zange 27 aufgenommen werden, wobei die Zange 27 auf die Stützfläche 26 mit einer Einpresskraft gedrückt wird. Die Einpresspins 8, 10 können zusätzlich während des Einpressvorgangs kraftschlüssig zwischen den Zangenbacken der Zange 27 gehalten werden, um einen Teil der auf das Stützelement 24 ausgeübten axialen Einpresskraft aufzunehmen.

Das Stützelement 24 teilt jeden Einpresspin 8, 10 in zwei Teile. Das kurze Ende dient als Anwickelstift 28, 30 für den Spulendraht 6. An das andere lange Ende ist die Einpresszone 20, 22 angeprägt.

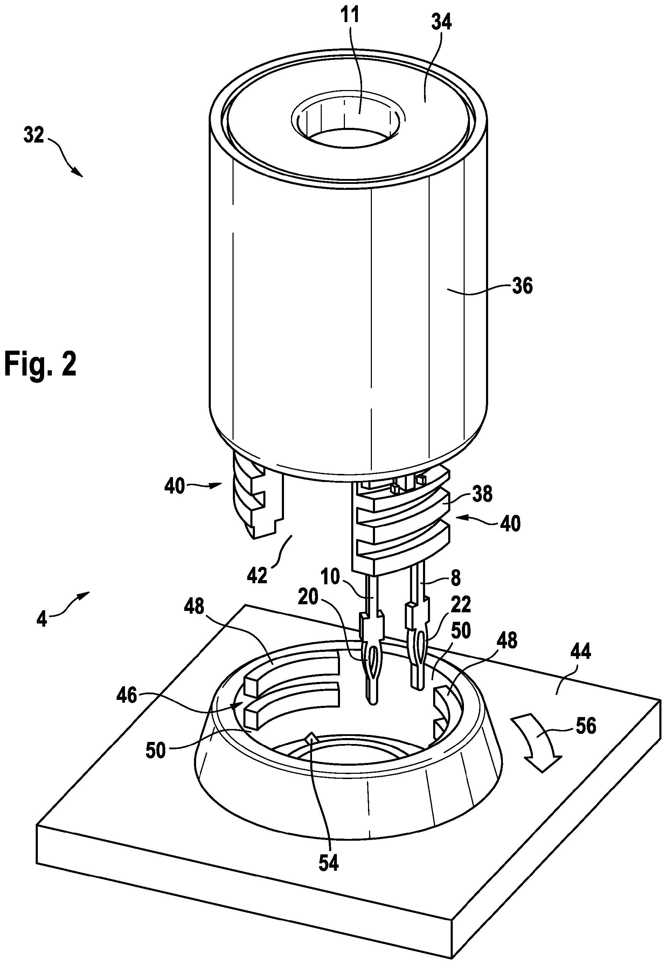

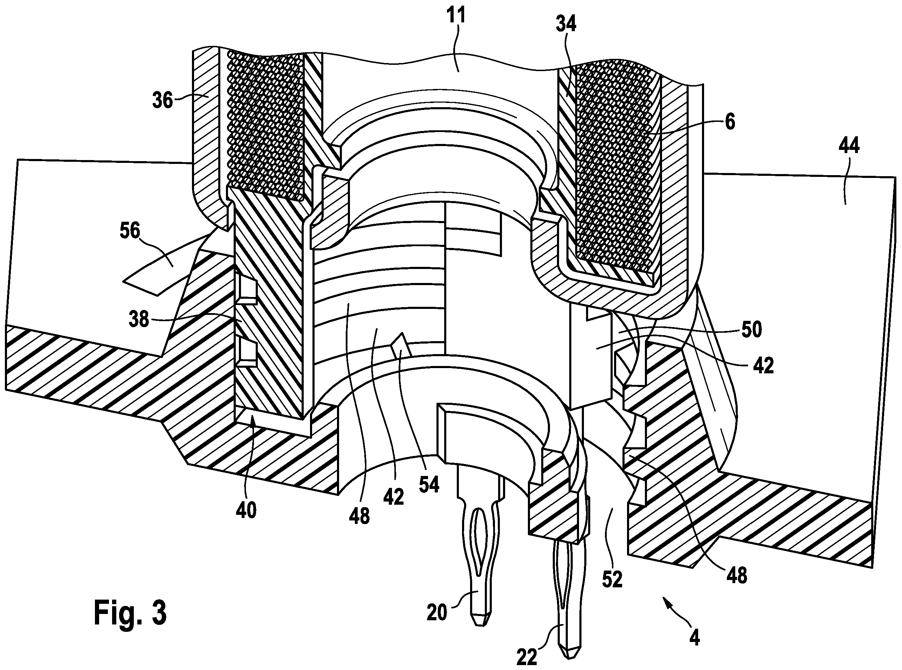

Die Fig. 2 und 3 zeigen ein Ausführungsbeispiel einer Spule 32 mit einer Vorrichtung 4 gemäß der Erfindung. In den Fig. 2 und 3 werden zu Fig. 1 gleiche Elemente mit gleichen Bezugszeichen versehen und nicht noch einmal beschrieben.

Die Spule 32 umfasst den Spulendraht 6, einen Spulenträger 34, auf den der Spulendraht 6 aufgewickelt ist und einen Jochring 36, in den der den Spulendraht 6 tragende Spulenträger 34 eingesetzt ist.

An der den Einpresspins 8, 10 zugewendeten Seite des Spulenträgers 34 ist ein Außengewinde 38 angespritzt. Das Außengewinde 38 weist drehsymmetrisch angeordnete Gewindebereiche 40 und Freibereiche 42 auf. Das Außengewinde 38 kann in ein an einem Gegenstück 44 ausgebildetes Innengewinde 46 eingeschraubt werden. Analog zum Außengewinde 38 weist das Innengewinde 46 drehsymmetrisch angeordnete Gewindebereiche 48 und Freibereiche 50 auf.

Zum Verbinden der Spule 32 mit dem Gegenstück 44 können die Gewindebereiche 40 des Außengewindes 38 in die Freibereiche 50 des Innengewindes 46 eingeführt werden. Durch ineinander Verschrauben des Außengewindes 38 und des Innengewindes 46 kann ein Formschluss zwischen dem Spulenträger 34 und dem Gegenstück 44 hergestellt werden.

Das Gegenstück 44 weist ferner eine Durchgangsöffnung 52 auf, durch die im Formschluss die Einpresspins 8, 10 geführt werden können. Wird daher auf der zur Spule 32 hin gewendeten Seite des Gegenstückes 44 eine Kraft axial zu den Einpresspins 8, 10 aufgebracht, kann diese auf die Einpresspins 8, 10 übertragen werden, ohne die in den Fig. 2 und 3 nicht gezeigten Kontaktstellen 16, 18 aus Fig. 1 zu beschädigen.

Das Gegenstück 44 kann beispielsweise ein Gehäuse sein, in dem die nicht gezeigte Leiterplatte aufgenommen werden kann, die mit der Spule 32 elektrisch kontaktiert werden soll. Zur richten Ausrichtung der Spule 32 am Gehäuse über den Formschluss aus Außengewinde 38 und Innengewinde 46 kann ein Anschlag 54 in der Öffnung 52 vorgesehen sein, an den beispielsweise der zweite Einpresspin 10 beim Eindrehen des Außengewindes 38 in das Innengewinde 46 anschlägt. Auf diese Weise ist die Ausrichtung der Spule 32 am Gegenstück 44 fest vorgegeben.

Die Drehrichtung des Außengewindes 38 im Innengewinde 46 kann durch einen Pfeil 56 angezeigt werden.

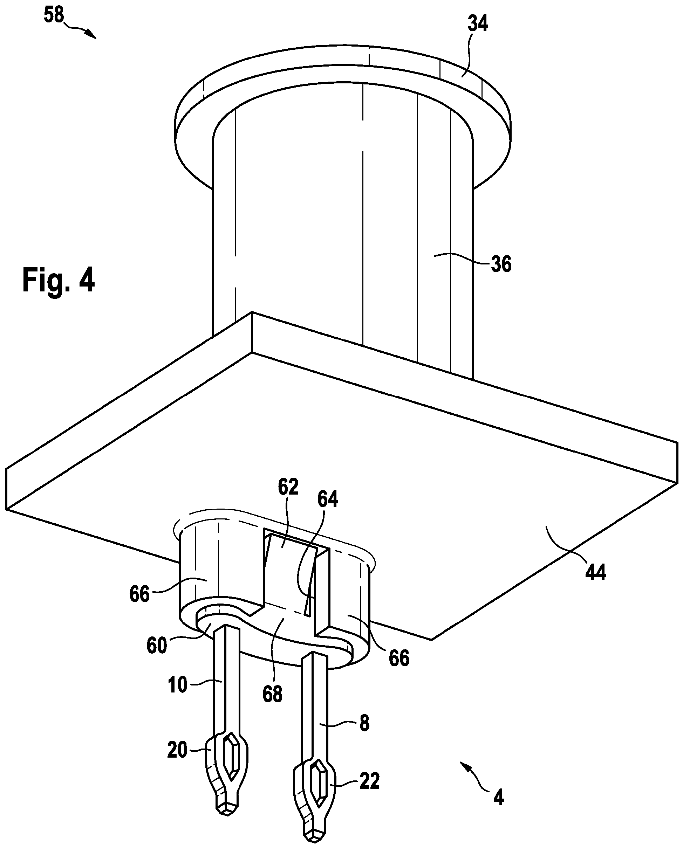

Die Fig. 4 zeigt ein zweites Ausführungsbeispiel einer Spule 58 mit einer Vorrichtung 4 gemäß der Erfindung. In Fig. 4 werden zu den Fig. 1 bis 3 gleiche Elemente mit gleichen Bezugszeichen versehen und nicht noch einmal beschrieben.

In Fig. 4 ist an die Unterseite des Spulenträgers 34 ein Vorsprung 60 mit einem Schnapphaken 62 angespritzt. Der Vorsprung 60 wird formschlüssig durch eine Öffnung 64 im Gegenstück 44 geführt, so dass der Schnapphaken 64 mit dem Gegenstück 44 verrasten kann.

Zur Stabilisierung des Vorsprungs 60 in der Öffnung 64 können auf der von der Spule 58 abgewendeten Seite des Gegenstücks 44 zwei Wände 66 angeordnet sein, die einerseits den Vorsprung 60 formschlüssig aufnehmen andererseits aber einen Schlitz 68 ausbilden, in dem der Schnapphaken 62 mit dem Gegenstück verrasten kann.

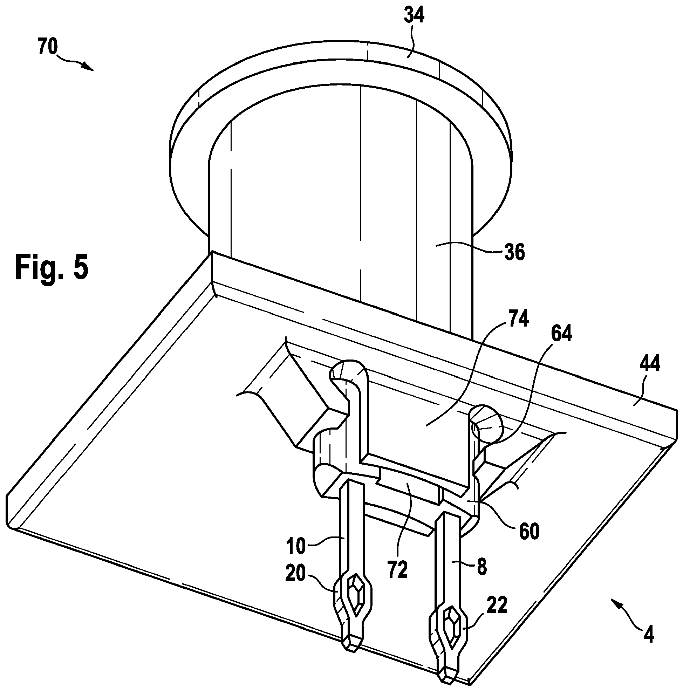

Die Fig. 5 zeigt ein drittes Ausführungsbeispiel einer Spule 70 mit einer Vorrichtung 4 gemäß der Erfindung. In Fig. 5 werden zu den Fig. 1 bis 4 gleiche Elemente mit gleichen Bezugszeichen versehen und nicht noch einmal beschrieben.

In Fig. 5 ist an die Unterseite des Spulenträgers 34 der Vorsprung 60 mit einer Aufnahmetaschen 72 angespritzt. Der Vorsprung 60 wird formschlüssig durch die Öffnung 64 im Gegenstück 44 geführt. An die von der Spule 70 abgewendete Seite des Gegenstücks 44 ist zudem eine Wand 74 mit einem nicht gezeigten Schnapphaken angespritzt, wobei der nicht gezeigte Schnapphaken in der in Fig. 5 gezeigten Stellung des Vorsprungs 60 mit der Aufnahmetasche 72 verrastet ist.

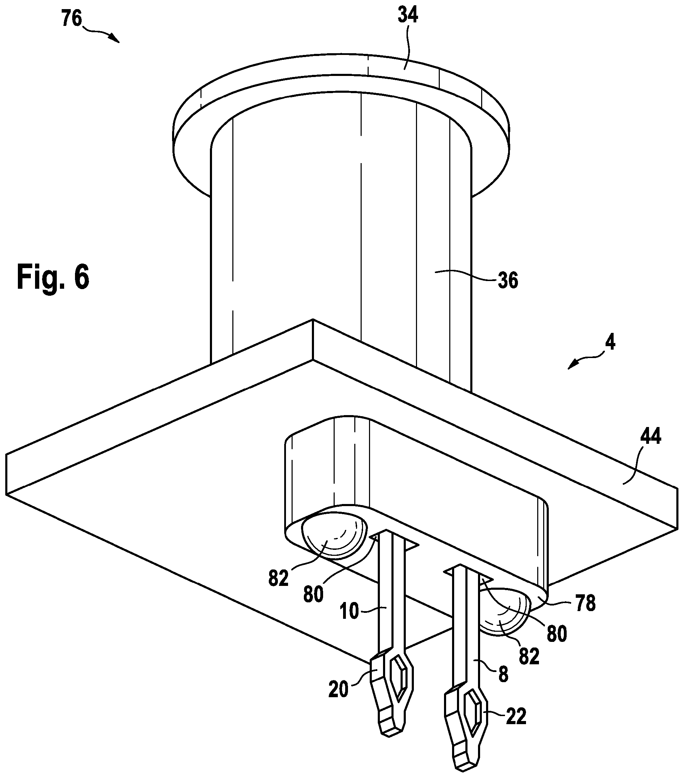

Die Fig. 6 zeigt ein viertes Ausführungsbeispiel einer Spule 76 mit einer Vorrichtung 4 gemäß der Erfindung. In Fig. 6 werden zu den Fig. 1 bis 5 gleiche Elemente mit gleichen Bezugszeichen versehen und nicht noch einmal beschrieben.

In Fig. 6 ist an die Unterseite des Spulenträgers 34 der Vorsprung 60 angespritzt, jedoch nicht gezeigt, da er in einer Tasche 78 an der von der Spule 76 abgewendeten Seite des Gegenstücks 44 aufgenommen ist. Die Tasche 78 weist zwei Öffnungen 80 auf, die von den Einpresspins 8, 10 durchdrungen werden. Über weitere zwei nicht gezeigte Öffnungen sind Nietelemente 82 geführt, die mit dem Vorsprung 60 verbunden sind und diesen in der Tasche 78 halten. Die Nietelemente 82 können beispielsweise durch Heißverstemmen am Vorsprung 60 angebracht werden, wenn dieser bereits in der Tasche 78 aufgenommen ist.

## Patentansprüche

1. Elektrisches Bauelement (2, 32, 58, 70, 76) umfassend:
- einen elektrischen Anschluss (16, 18) zum elektrischen Verbinden mit einer Leiterplatte;
- eine Vorrichtung (4) zum elektrischen Verbinden des elektrischen Bauelementes mit der Leiterplatte umfassend einen elektrisch leitfähigen Anschlussstift (8, 10) mit einem ersten Kontaktbereich (20, 22) zum elektrischen Anschluss an die Leiterplatte und einem zweiten Kontaktbereich (28, 30) zum elektrischen Anschluss an das elektrische Bauelement (2, 32, 58, 70, 76);
ein den Anschlussstift (8, 10) haltendes Stützelement (24, 38, 60) zwischen dem ersten Kontaktbereich (20, 22) und zweiten Kontaktbereich (28, 30), das zur Aufnahme einer Kraft in Axialrichtung des Anschlussstiftes (8, 10) vorgesehen ist,
wobei der zweite Kontaktbereich (28, 30) des Anschlussstiftes (8, 10) an den elektrischen Anschluss (16, 18) angeschlossen ist **dadurch gekennzeichnet, dass** das Stützelement (24, 38, 60) zur formschlüssigen Verbindung mit einem für den Formschluss ausgebildeten Gegenstück (44), das zur Aufnahme der Kraft in Axialrichtung des Anschlussstiftes (8, 10) vorgesehen ist, ausgebildet ist, um das elektrische Bauelement an dem Gegenstück zu montieren.

2. Elektrisches Bauelement (2, 32, 58, 70, 76) nach Anspruch 1, wobei die formschlüssige Verbindung eine eindeutige relative Lage des Stützelementes (24, 38, 60) zum Gegenstück (44) definiert.

3. Elektrisches Bauelement (2, 32, 58, 70, 76) nach einem der vorstehenden Ansprüche, wobei das Stützelement (24, 38, 60) ein um den Anschlussstift umgespritztes Spritzgusselement ist.

4. Elektrisches Bauelement (2, 32, 58, 70, 76) nach Anspruch 1-3, umfassend einen Spulenkörper (6) mit dem elektrischen Anschluss (16, 18).

5. Elektrisches Bauelement (2, 32, 58, 70, 76) nach Anspruch 4, umfassend einen den Spulenkörper (6) umgebenden Jochring (36).

6. Schaltung umfassend:
- eine Leiterplatte; und
- ein mit der Leiterplatte elektrisch kontaktiertes elektrisches Bauelement (2, 32, 58, 70, 76) nach einem der vorstehenden Ansprüche.

## Claims

1. Electrical component (2, 32, 58, 70, 76) comprising:
- an electrical terminal (16, 18) for electrical connection to a printed circuit board;
- an apparatus (4) for electrical connection of the electrical component to the printed circuit board, said apparatus comprising
an electrically conductive terminal pin (8, 10) having a first contact region (20, 22) for electrical connection to the printed circuit board and a second contact region (28, 30) for electrical connection to the electrical component (2, 32, 58, 70, 76);
a support element (24, 38, 60) that holds the terminal pin (8, 10) between the first contact region (20, 22) and the second contact region (28, 30), which support element is provided to absorb a force in the axial direction of the terminal pin (8, 10),
wherein the second contact region (28, 30) of the terminal pin (8, 10) is connected to the electrical terminal (16, 18)
**characterized in that** the support element (24, 38, 60) is designed for form-fitting connection to a mating piece (44), which is designed for the form fit and which is provided to absorb the force in the axial direction of the terminal pin (8, 10), in order to mount the electrical component on the mating piece.

2. Electrical component (2, 32, 58, 70, 76) according to Claim 1, wherein the form-fitting connection defines a clear relative position of the support element (24, 38, 60) with respect to the mating piece (44).

3. Electrical component (2, 32, 58, 70, 76) according to either of the preceding claims, wherein the support element (24, 38, 60) is an injection-moulded element that is encapsulated by injection-moulding around the terminal pin.

4. Electrical component (2, 32, 58, 70, 76) according to Claim 1-3, comprising a coil former (6) comprising the electrical terminal (16, 18).

5. Electrical component (2, 32, 58, 70, 76) according to Claim 4, comprising a yoke ring (36) that surrounds the coil former (6).

6. Circuit comprising:
- a printed circuit board; and
- an electrical component (2, 32, 58, 70, 76) according to one of the preceding claims that is electrically contact-connected to the printed circuit board.

## Revendications

1. Composant électrique (2, 32, 58, 70, 76) comprenant :
- une borne électrique (16, 18) destinée à être reliée électriquement à une carte de circuit imprimé ;
- un dispositif (4) destiné à relier électriquement le composant électrique à la carte de circuit imprimé, comprenant un plot de connexion électriquement conducteur (8, 10) ayant une première région de contact (20, 22) pour le raccordement électrique à la carte de circuit imprimé et une seconde région de contact (28, 30) pour le raccordement électrique au composant électrique (2, 32, 58, 70, 76) ;
un élément de support (24, 38, 60) maintenant le plot de raccordement (8, 10) entre la première zone de contact (20, 22) et la seconde zone de contact (28, 30), qui est prévu pour recevoir une force dans la direction axiale du plot de raccordement (8, 10),
dans lequel la seconde zone de contact (28, 30) du plot de raccordement (8, 10) est raccordée à la borne électrique (16, 18),
**caractérisé en ce que** l'élément de support (24, 38, 60) est conçu pour une liaison par complémentarité de forme avec une pièce complémentaire (44) conçue pour la complémentarité de forme et prévue pour recevoir la force dans la direction axiale du plot de raccordement (8, 10) afin de monter le composant électrique sur la pièce complémentaire.

2. Composant électrique (2, 32, 58, 70, 76) selon la revendication 1, dans lequel la liaison par complémentarité de forme définit une position relative unique de l'élément de support (24, 38, 60) par rapport à la pièce complémentaire (44).

3. Composant électrique (2, 32, 58, 70, 76) selon l'une des revendications précédentes, dans lequel l'élément de support (24, 38, 60) est un élément moulé par injection autour du plot de raccordement.

4. Composant électrique (2, 32, 58, 70, 76) selon la revendication 1-3, comprenant un corps de bobine (6) muni de la borne électrique (16, 18).

5. Composant électrique (2, 32, 58, 70, 76) selon la revendication 4, comprenant un anneau de culasse (36) entourant le corps de bobine (6}.

6. Circuit comprenant :
- une carte de circuit imprimé ; et
- un composant électrique (2, 32, 58, 70, 76) selon l'une des revendications précédentes, en contact électrique avec la carte de circuit imprimé.
